Europäisches Patentamt

European Patent Office

Office européen des brevets

(11) Publication number: **0 200 059 B1**

# EUROPEAN PATENT SPECIFICATION

(45) Date of publication of patent specification: **01.07.92**  (51) Int. Cl.5: **H01L 21/285**

(21) Application number: **86105004.5**

(22) Date of filing: **11.04.86**

(54) **A method of forming an ohmic contact to a group III-V semiconductor and a semiconductor intermediate manufacturing product.**

(30) Priority: **23.04.85 US 726205**

(43) Date of publication of application:
**10.12.86 Bulletin 86/45**

(45) Publication of the grant of the patent:
**01.07.92 Bulletin 92/27**

(84) Designated Contracting States:
**DE FR GB IT**

(56) References cited:
EP-A- 0 130 416    EP-A- 0 164 720
FR-A- 2 387 514    US-A- 4 298 403
US-A- 4 398 963    US-A- 4 540 446

(73) Proprietor: **International Business Machines Corporation**
**Old Orchard Road**
**Armonk, N.Y. 10504(US)**

(72) Inventor: **Jackson, Thomas Nelson**
**80 Cortlandt Avenue**
**Peekskill New York 10566(US)**
Inventor: **Kirchner, Peter Daniel**
**Route 9**
**Garrison New York 10524(US)**
Inventor: **Pettit, George David**
**Austin Road**
**Mahopac, New York 10541(US)**
Inventor: **Rutz, Richard Frederick**
**Route 2 Box 70**
**Cold Spring New York 10516(US)**
Inventor: **Woodall, Jerry Macpherson**
**336 Cherry Street**
**Bedford Hills New York 10507(US)**

(74) Representative: **Moss, Robert Douglas**
**IBM United Kingdom Limited Intellectual Property Department Hursley Park**
**Winchester Hampshire SO21 2JN(GB)**

## Description

This invention relates to a method of forming an ohmic contact to a device region in the surface of an extrinsic conductivity type group III-V semiconductor crystal, and to a semiconductor intermediate manufacturing product.

At the present state of the art, the group III-V intermetallic semiconductor crystal materials, of which the material gallium arsenide (GaAs) is receiving the most attention, have a number of advantages, however, there is a major impediment to the practice of technology involving these semiconductor materials in that a barrier to current flow is inherent when an external electrode is applied to the surface.

In the practice of this technology, especially in instances where broad area integrated circuits are placed with very close spacing, alloying operations, ion implantation operations with subsequent annealing, and diffusion operations all temperature based operate to change the crystal to metal interface characteristics so that many electrical contact structures have thermal stability only over narrow temperature ranges and reproducibility requires constraints on the entire fabrication process.

EP-A-164720 discloses the provision of a group III-V intermetallic semiconductor crystal through the use of an amphoteric dopant that is caused to occupy donor sublattice crystal sites in the region adjacent to the surface on which the metallic contact is to be applied as the crystal is grown. The control of the interface achieved provides temperature stability and reproducibility.

US-A-4298403 discloses a method of forming a reliable contact for GaAs devices by vacuum deposition of a p-type layer of germanium over the GaAs crystal, followed by ion implantation of phosporous or arsenic ions into the germanium. The device is then capped and annealed to activate the germanium into an $n^+$ layer. A further capping and annealing stage can be used to drive some of the germanium into the GaAs crystal. US-A-4540446, an intermediate document, discloses a somewhat similar structure which also comprises a GaAs crystal covered by a Ge layer with As implants.

The invention provides, according to one aspect, a method of forming an ohmic contact to a device region in the surface of an extrinsic conductivity type group III-V semiconductor crystal, the method comprising the steps of:
providing an amphoteric dopant layer of silicon on the surface of the group III-V crystal,
providing in said silicon layer at the desired location of the ohmic contact a localised quantity of atoms of the element of the group III-V crystal which is capable of imparting with the amphoteric dopant said extrinsic conductivity type, and
heating the structure at a sufficient temperature and for a sufficient time to diffuse atoms from said silicon layer into the surface of the crystal.

The invention also provides a semiconductor intermediate manufacturing product comprising:
a monocrystalline group III-V intermetallic semiconductor crystal of a particular extrinsic conductivity type having at least one surface in which semiconductor devices are to be formed
an amphoteric dopant silicon layer for said semiconductor crystal in contact with a surface of the crystal, and, in a desired location in said silicon layer, a localised concentration of atoms of an element of said III-V intermetallic compound crystal that can in conjunction with said amphoteric dopant impart the same conductivity type as said extrinsic conductivity type.

How the invention can be carried out will now be described by way of example, with reference to the accompanying drawings, in which:

Figure 1 represents a portion of an integrated circuit in the course of the formation of a contact to a surface region thereof;

Figure 2 is a generalised energy band diagram of the contact formed in the integrated circuit portion of Figure 1;

Figure 3 is the current voltage characteristic of an ohmic contact; and

Figure 4 is the current voltage characteristic of a rectifying contact.

It has been found that a semiconductor device substrate of a group III-V intermetallic compound crystal with a layer of an amphoteric dopant on the device receiving surface will provide an intermediate manufacturing product in the fabrication of semiconductor integrated circuits that has the advantages of both ohmic and rectifying contacts of high temperature stability and reproducibility.

The amphoteric dopant layer on the device surface of the group III-V intermetallic semiconductor crystal where external electrical metal contacts are to be placed provides a temperature stable, reproducible rectifying barrier by pinning the Fermi level at the surface.

A dopant is defined as amphoteric when it can impart either n or p type conductivity.

The amphoteric dopant layer on the device surface of the group III-V intermetallic semiconductor crystal, where external electrical metal contacts are to be placed, provides an ohmic contact to the crystal in the localised presence of the group V element of the crystal in the amphoteric dopant layer.

Atoms of amphoteric dopant from the amphoteric dopant layer in the presence of an excess of atoms of a particular sublattice of the group III-V crystal in a temperature cycle will enter the region of the crystal adjacent the surface to reside on the opposite sublattice site. This operates to reduce the width of the depletion region at the metal-crystal interface to a width that will permit quantum mechanical tunnelling, providing thereby an ohmic contact. As an example, in the presence of an excess of group V atoms in an amphoteric dopant layer on a group III-V crystal, the amphoteric dopant will enter the surface of the crystal and reside primarily on donor sublattice sites, thereby reducing the surface depletion width.

The ability to provide either ohmic or rectifying contacts through providing a selected localised pattern of the group V element in the amphoteric dopant layer for the ohmic contacts permits later personalisation decisions in the fabrication of integrated circuit arrays. While the contacts have improved temperature stability, the personalisation advantage permits fabrication with reduced subsequent processing.

The description will be primarily concerned with the preferred III-V compound GaAs n-type crystal using the amphoteric dopant Si although in the light of the principles set forth various substitutions will be readily apparent to one skilled in the art.

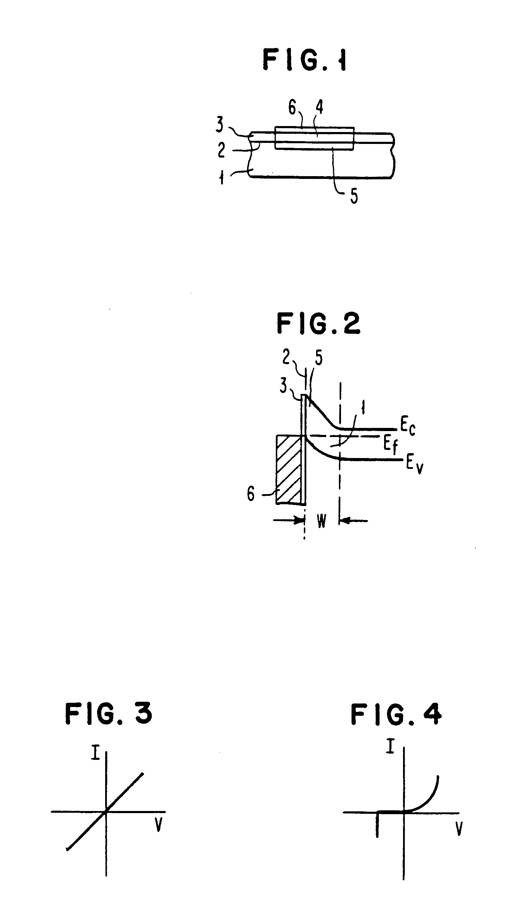

Referring to Figure 1, a schematic view of a portion of an integrated circuit is provided where two types of external electrical contacts in an intermediate manufacturing product are illustrated. In Figure 1, a III-V intermetallic semiconductor monocrystalline body 1 of GaAs serves as the device portion. The body 1 has a surface 2 in which devices are fabricated and electrical contacts are positioned. A layer of an amphoteric dopant of silicon 3 is positioned on the surface 2.

A localised quantity 4 of the group V in crystal element As is added to the Si layer 3. The As quantity 4 permits the Si layer 3 when diffusing into the crystal 1 through the surface 2 to form a region 5 of Si atoms on donor Ga sublattice sites which reduce the depletion width of the barrier at the surface 2 permitting a tunnelling ohmic contact. A metal external electrical connection 6 is placed over the region 4.

Referring to Figure 2, an energy band diagram is provided that illustrates the conditions that result in both ohmic and rectifying contact performance. Like reference numerals with Figure 1 are provided for explanation clarity. At the silicon-to-crystal interface 2, the silicon 3 upon heating in the presence of the localised group V in element As diffuses into GaAs crystal 1 onto the donor or Ga sublattice sites in the region 5 and effectively reduces the depletion width labelled W to a value below approximately 100 nm that permits quantum mechanical tunnelling and hence ohmic contact performance.

The electrical performance of the ohmic contact is illustrated in Figure 3. The perfomance and advantages can be readily seen in connection with both Figures 2 and 3 wherein in Figure 2 the depletion width W permits the tunnelling through any barrier so that current flow is linear in both directions as shown in the current-voltage characteristic curve of Figure 3.

The conditions that result in rectifying contact performance will now be described. In the absence of the localised group V in element, the silicon layer 3 between the metal 6 and the crystal surface 2 upon heating diffuses slightly into the surface 2 on both donor and acceptor sublattices so that its net doping effect is insufficient to produce dominant tunnelling performance and the electrical performance is rectifying as illustrated in Figure 4.

The amphoteric dopant layer of silicon for contact to GaAs provides contacts stable to 1000°C. While germanium is usable under some conditions, the germanium-gallium arsenide eutectic temperature of 680°C is too low to accommodate some processing temperatures that may reach 900°C.

Referring to Figure 1, the invention is best practiced using a n-doped GaAs crystal layer for the body 1, using Si for the amphoteric dopant layer 3 and As for the crystal atom ingredient. The technique of molecular beam epitaxy is employed for fabrication. In molecular beam epitaxy, the various ingredients are delivered to the epitaxial growth site in the form of a beam of atomic particles. The gallium arsenide crystal 1 is grown as far as the interface 2 with the silicon 3. The silicon layer 3 is then grown on the interface 2 in a thickness from a minimum of a fraction of a monolayer to several tens of nanometers with a preferred thickness of some 20 nm. The arsenic 4 is ion implanted into the silicon in selected areas where ohmic performance is desired. A temperature cycle of 600° to 1000° C for a few seconds to a few minutes is then provided.

## Claims

1. A method of forming an ohmic contact to a device region in the surface of an extrinsic conductivity type group III-V semiconductor crystal, the method comprising the steps of:
   providing an amphoteric dopant layer of silicon (3) on the surface of the group III-V crystal (1),
   providing in said silicon layer at the desired location of the ohmic contact a localised quantity of atoms (4) of the element of the group III-V crystal which is capable of imparting with the amphoteric dopant said extrinsic conductivity type, and
   heating the structure at a sufficient temperature and for a sufficient time to diffuse atoms (5) from said silicon layer into the surface of the crystal.

2. A method as claimed in claim 1, in which said silicon layer is 20 nm thick.

3. A method as claimed in claim 1 or claim 2, in which the group III-V semiconductor crystal is of GaAs.

4. A method as claimed in claim 3, in which the GaAs is of n-type conductivity.

5. A method as claimed in claim 3 or 4, in which the localised quantity of atoms is comprised of As atoms.

6. A method as claimed in claim 5, in which the As atoms are introduced by ion implantation.

7. A method as claimed in any preceding claim, including simultaneously forming a rectifying contact to another device region in the surface of the crystal by arranging that atoms of said element are not introduced into said silicon layer at the desired location of the rectifying contact.

8. A semiconductor intermediate manufacturing product comprising
a monocrystalline group III-V intermetallic semiconductor crystal (1) of a particular extrinsic conductivity type having at least one surface in which semiconductor devices are to be formed,
an amphoteric dopant silicon layer (3) for said semiconductor crystal in contact with a surface of the crystal, and, in a desired location in said silicon layer, a localised concentration of atoms (4) of an element of said III-V intermetallic compound crystal that can in conjunction with said amphoteric dopant impart the same conductivity type as said extrinsic conductivity type.

9. A product as claimed in claim 8, in which said silicon layer is 20 nm (nanometers) thick.

**Revendications**

1. Procédé pour la formation d'un contact ohmique sur une région de dispositif dans la surface d'un cristal semi-conducteur composé III-V de type de conductivité extrinsèque, le procédé comprenant les étapes de:
former une couche dopante amphotère de silicium (3) sur la surface du cristal composé III-V,

fournir dans ladite couche de silicium à l'emplacement voulu du contact ohmique, une quantité localisée d'atomes (4) de l'élément du cristal composé III-V qui est capable de communiquer avec le dopant amphotère, ledit type de conductivité extrinsèque, et
chauffer la structure à une température suffisante et pendant un temps suffisant pour diffuser des atomes (5) depuis ladite couche de silicium jusque dans la surface du cristal.

2. Procédé selon la revendication 1, dans lequel ladite couche de silicium a une épaisseur de 20 nm.

3. Procédé selon les revendications 1 ou 2, dans lequel le cristal semi-conducteur composé III-V est GaAs.

4. Procédé selon la revendication 3, dans lequel GaAs est du type de conductivité n.

5. Procédé selon les revendications 3 ou 4, dans lequel la quantité localisée d'atomes est constituée d'atomes As.

6. Procédé selon la revendication 5, dans lequel les atomes As sont introduits par implantation ionique.

7. Procédé selon l'une quelconque des revendications précédentes, comprenant la formation simultanée d'un contact de redressement sur une autre région de dispositif dans la surface du cristal en faisant en sorte que les atomes dudit élément ne soient pas introduits dans ladite couche de silicium à l'emplacement voulu du contact de redressement.

8. Produit de fabrication semi-conducteur intermédiaire comprenant:
un cristal semi-conducteur intermétallique composé III-V monocristallin (1) de type de conductivité extrinsèque particulier ayant au moins une surface dans laquelle doivent être formés les dispositifs semi-conducteurs,
une couche dopante amphotère de silicium (3) pour ledit cristal semi-conducteur en contact avec une surface du cristal et, dans un emplacement voulu de ladite couche de silicium, une concentration localisée d'atomes (4) d'un élément dudit cristal intermétallique composé III-V qui peut, simultanément avec ledit dopant amphotère, communiquer le même type de conductivité que ledit type de conductivité extrinsèque.

9. Produit selon la revendication 8, dans lequel ladite couche de silicium a une épaisseur de 20 nm (nonomètres).

**Patentansprüche**

1. Verfahren zum Herstellen eines ohmschen Kontaktes an einem Elementenbereich in der Oberfläche eines Gruppe III-V Halbleiterkristalls, der ein Typ mit Störstellenleitung ist, wobei das Verfahren die folgenden Schritte enthält:
auf der Oberfläche des Gruppe III-V Kristalls (1) wird eine amphotere Dopierungsschicht aus Silizium (3) vorgesehen,
an der gewünschten Stelle des ohmschen Kontakts wird in der Siliziumschicht eine lokalisierte Menge von Atomen (4) des Elements der Gruppe III-V Kristalls vorgesehen, welche mit dem amphoteren Dotierstoff den Typ mit Störstellenleitung schaffen kann, und
die Struktur wird bei einer hinreichenden Temperatur und während einer hinreichenden Zeitdauer erwärmt, um Atome (5) aus der Siliziumschicht in die Oberfläche des Kristalls eindiffundieren zu lassen.

2. Verfahren nach Anspruch 1, bei welchem die Siliziumschicht 20 nm dick ist.

3. Verfahren nach Anspruch 1 oder 2, bei welchem der Gruppe III-V Halbleiterkristall aus GaAs besteht.

4. Verfahren nach Anspruch 3, bei welchem das GaAs n-leitend ist.

5. Verfahren nach Anspruch 3 oder 4, bei welchem die lokalisierte Menge aus Atomen aus As-Atomen besteht.

6. Verfahren nach Anspruch 5, bei welchem die As-Atome mittels Ionenimplantation eingebracht werden.

7. Verfahren nach einem der vorgehenden Ansprüche, bei welchem gleichzeitig ein gleichrichtender Kontakt mit einem anderen Elementenbereich in der Oberfläche des Kristalls ausgebildet wird, indem jene Atome des genannten Elements, die nicht in die Siliziumschicht eingebracht wurden, an der gewünschten Stelle des gleichrichtenden Kontakts angeordnet werden.

8. Halbleiterzwischenprodukt, welches aufweist einen monokristallinen, intermetallischen Gruppe III-V Halbleiterkristall (1), der ein Typ mit bestimmter Störstellenleitung ist, und zumindest eine Oberfläche besitzt, in der Halbleiterelemente ausgebildet werden sollen,
eine amphotere Dopierungsschicht (3) aus Silizium für den Halbleiterkristall, die in Kontakt mit einer Oberfläche des Kristalls steht, und - an einer gewünschten Stelle in der Siliziumschicht - eine lokalisierte Konzentration von Atomen (4) eines Elements des intermetallischen III-V Verbindungskristalls, die in Verbindung mit dem amphoteren Dotierstoff den gleichen Leitungstyp wie der Typ mit Störstellenleitung schaffen kann.

9. Produkt nach Anspruch 8, bei welchem die Siliziumschicht 20 nm (Nanometer) dick ist.

# FIG. 1

# FIG. 2

$E_c$

$E_f$

$E_v$

W

# FIG. 3

I

V

# FIG. 4

I

V